# EUROPÄISCHE PATENTSCHRIFT

(11) **EP 3 739 758 B1**
(45) Veröffentlichungstag und Bekanntmachung des Hinweises auf die Patenterteilung: **29.10.2025**
(21) Anmeldenummer: 20174054.5
(22) Anmeldetag: 12.05.2020
(51) Int. Cl.: H03K 17/96, H03K 17/972, H03K 17/97

(54) **INTELLIGENTE SENSORVORRICHTUNG**
INTELLIGENT SENSOR DEVICE
DISPOSITIF CAPTEUR INTELLIGENT

(30) Priorität: 17.05.2019 DE 102019113096
(43) Veröffentlichungstag der Anmeldung: 18.11.2020
(73) Patentinhaber: Huf Hülsbeck & Fürst GmbH & Co. KG, 42551 Velbert (DE)
(72) Erfinder: Witte, Martin, 48683 Ahaus (DE); Gorenzweig, Igor Alexander, 42109 Wuppertal (DE); Löpke, Christian, 42579 Heiligenhaus (DE); Schmidt, Jens, 40699 Erkrath (DE)
(74) Vertreter: Bals & Vogel Patentanwälte PartGmbB

(56) Entgegenhaltungen:
- WO-A2-2008/071196
- DE-A1- 102015 109 548
- US-A1- 2016 226 521
- US-B1- 8 040 142

## Beschreibung

Die Erfindung betrifft ein Verfahren zum Betreiben einer Sensorvorrichtung für eine Betätigung durch eine Deformation eines Bedienkörpers, ein Computerprogrammprodukt, eine Sensorvorrichtung für eine Betätigung durch eine Deformation eines Bedienkörpers sowie ein Fahrzeug.

Aus dem Stand der Technik sind tast- und/oder druckempfindliche Sensoren sowie Näherungssensoren bei Fahrzeugen bekannt. Die druckempfindlichen Sensoren sind dabei meist von außen zugänglich oder mit einem Betätigungselement verbunden, welches bewegbar ist, um den Drucksensor auszulösen. Als Reaktion auf eine Auslösung des Sensors werden dabei häufig Fahrzeugfunktionen aktiviert. Z. B. kann ein elektronisches Schloss aktiviert werden.

Dabei ist jedoch von Nachteil, dass die tast- und/oder druckempfindlichen Sensoren im Normalfall einen Durchbruch einer Außenfläche erfordern, was konstruktive Einschränkungen sowie gestalterische Nachteile mit sich bringen kann. Daher ist es bspw. aus der DE 10 2016 122 550 A1 bekannt einen Sensor hinter einem Fahrzeugblech anzuordnen und die Deformation des Fahrzeugbleches zu erkennen. Dadurch kann der Sensor unabhängig von der Fahrzeugaußenfläche an einem Fahrzeugblech montiert werden, wobei dessen Betätigungsfunktion erhalten bleibt, indem der Sensor insbesondere elastische Verformungen des Bleches detektiert, wenn ein Benutzer von außen auf das Blech drückt. Es hat sich jedoch herausgestellt, dass äußere Einflüsse, wie z.B. Temperaturänderungen zu einer Verformung des Bleches führen können, die daraufhin eine Fehlauslösung bzw. Fehlerkennung des Sensors begünstigen können. Darüber hinaus ist es wünschenswert auch unbeabsichtigte Berührungen des Fahrzeugbleches im Bereich um den Sensor von tatsächlichen Betätigungshandlungen unterscheiden zu können.

Das Dokument WO 2008/071196 A2 zeigt einen ähnlichen Sensor für metallische Oberflächen.

Es ist somit eine Aufgabe der vorliegenden Erfindung voranstehende aus dem Stand der Technik bekannte Nachteile zumindest teilweise zu beheben. Insbesondere ist eine Aufgabe der vorliegenden Erfindung, ein Verarbeiten einer Deformation und/oder ein Erkennen einer Betätigung einer Sensorvorrichtung zu verbessern, vorzugsweise durch eine verbesserte Genauigkeit bei einer Deformationserkennung, insbesondere um Fehlauslösungen zu reduzieren oder zu vermeiden.

Die voranstehende Aufgabe wird gelöst durch ein Verfahren mit den Merkmalen des unabhängigen Verfahrensanspruch, ein Computerprogrammprodukt mit den Merkmalen unabhängigen Computerprogrammprodukt-Anspruchs, eine Sensorvorrichtung mit den Merkmalen des unabhängigen Vorrichtungsanspruchs sowie ein Kraftfahrzeug mit den Merkmalen des unabhängigen Fahrzeuganspruchs. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben worden sind, selbstverständlich auch im Zusammenhang mit dem erfindungsgemäßen Computerprogrammprodukt, der erfindungsgemäßen Sensorvorrichtung und/oder dem erfindungsgemäßen Fahrzeug und jeweils umgekehrt, sodass bzgl. der Offenbarung zu den einzelnen Erfindungsaspekten stets wechselseitig Bezug genommen wird bzw. werden kann.

Erfindungsgemäß umfasst ein Verfahren zum Betreiben einer Sensorvorrichtung für eine Betätigung, insbesondere durch einen Benutzer zum Auslösen einer elektrischen Funktion, durch eine Deformation eines Bedienkörpers, insbesondere eines Fahrzeuges, die folgenden Schritte:
- Erzeugen eines ersten Sensorsignals, insbesondere durch ein erstes Sensorelement, infolge der Deformation des Bedienkörpers,
- Erzeugen eines zweiten Sensorsignals, insbesondere durch ein zweites Sensorelement, infolge der Deformation des Bedienkörpers,
- Erkennen der Betätigung in Abhängigkeit von jeweils zumindest einer spezifischen Abweichungsrichtung des ersten und zweiten Sensorsignals von einer Referenz,
wobei über die Abweichungsrichtung unterscheidbar ist, ob es sich bei der Deformation um eine positive oder eine negative Auslenkung des Bedienkörpers handelt, wobei das Erkennen der Betätigung in Abhängigkeit der Abweichungsrichtungen ein Bewerten der Abweichungsrichtungen umfasst.

Das erste und zweite Sensorsignal können Messsignale von (einem ersten und zweiten) Sensorelementen einer Sensorvorrichtung sein. Idealerweise weist jedes Sensorelement ein eigenes Sensorsignal auf. Auch können mehr als zwei Sensorelemente bei der Sensorvorrichtung vorgesehen sein. Ferner ist es denkbar, dass die Messsignale der Sensorelemente beim Erzeugen der Sensorsignale zumindest teilweise ausgewertet werden. Der Bedienkörper kann z.B. ein bewegliches Teil eines Fahrzeugs umfassen. Vorzugsweise kann es sich bei dem Bedienkörper um ein Fahrzeugblech handeln. Das erste und zweite Sensorsignal können induktiv erzeugt werden, indem z.B. den Sensorsignalen zugeordnete Sensorelemente eine Spule aufweisen, um die induktive Messung zu ermöglichen, wenn sich ein magnetisierbarer und/oder elektrisch leitfähiger Körper den Sensorelementen durch die Deformation nähert. Es ist jedoch ebenso denkbar, dass bspw. eine Metallplatte oder eine metallische Beschichtung auf den Bedienkörper im Bereich der Sensorelemente aufgebracht, insbesondere aufgeklebt, ist, um in Folge einer Deformation des Bedienkörpers eine Auslenkung des Metallkörpers (auch in Form einer metallische Beschichtung) zu bewirken, welche durch die Sensorelemente detektierbar ist.

Unter der Referenz kann vorzugsweise ein Referenzsignal oder ein Referenzwert verstanden werden. Die spezifische Abweichungsrichtung des jeweiligen Sensorsignals kann eine Richtung einer Signalamplitude des jeweiligen Sensorsignals umfassen. Ferner kann die Abweichungsrichtung einen vollständig abweichenden Verlauf des ersten und/oder zweiten Sensorsignals umfassen, wenn z.B. aufgrund der Deformation das erste und/oder zweite Sensorsignal sich von der Referenz entfernt. Unter spezifisch kann insbesondere verstanden werden, dass die Abweichungsrichtung vorgegeben oder anlernbar ist, um die Deformation und/oder Betätigung zu erkennen. So kann z.B. ein Abbild der spezifischen Abweichungsrichtung vorgegeben sein, welches einen typischen Deformationszustand wiederspiegelt. Das Erkennen der Betätigung in Abhängigkeit der Abweichungsrichtungen kann somit ein Bewerten der Abweichungsrichtungen und/oder den Sensorsignale umfassen.

Dadurch dass zum Erkennen der Betätigung anhand der Deformation zumindest zwei Sensorsignale herangezogen werden, können Messfehler der einzelnen Signale ausgeglichen werden. Darüber hinaus ist über die Abweichungsrichtung unterscheidbar, ob es sich bei der Deformation um eine positive oder eine negative Auslenkung des Bedienkörpers handelt. Somit kann bspw. vorbestimmt sein, dass eine Auslösung einer Betätigungsfunktion dann durchgeführt wird, wenn zum einen eine Deformation festgestellt wird und diese zum anderen als Druck auf den Bedienkörper erkannt wird. Darüber hinaus kann über die spezifische Abweichungsrichtung des ersten und zweiten Sensorsignals ein Signalbild vorgegeben sein, welches ein Charakteristikum für eine bewusste (gewollte) Deformation des Bedienkörpers zum Auslösen einer Betätigung darstellt. So ist es bspw. denkbar, dass die Abweichungsrichtungen des ersten und zweiten Sensorsignals einen Druckzustand des Bedienkörpers aufzeigen, und deren jeweilige Signalamplitude den gleichen Ausschlag aufweist. Dadurch kann mit einer hohen Genauigkeit festgestellt werden, dass die Deformation zwischen den Sensorelementen stattgefunden hat oder stattfindet und somit z.B. zur Betätigung erkannt wird.

Vorzugsweise kann die Deformation beim Erkennen der Betätigung in Abhängigkeit der spezifischen Abweichungsrichtungen des ersten und zweiten Sensorsignals lokalisiert werden. Insbesondere kann anhand der spezifischen Abweichungsrichtungen des ersten und zweiten Sensorsignals ausgehend von der Referenz eine Position der Deformation erkannt werden. Weist z.B. das erste Sensorsignal eine negative Abweichungsrichtung auf und das zweite Sensorsignal eine positive Abweichungsrichtung, so kann davon ausgegangen werden, dass sich der Bedienkörper im Bereich des ersten Sensorelementes in einem Druckspannungszustand befindet und im Bereich des zweiten Sensorelementes in einem Zugspannungszustand, wobei der Druckspannungszustand zu einer Auslenkung des Bedienkörpers in Richtung der Sensorelemente führt und der Zugspannungszustand zu einer Auslenkung des Bedienkörpers entgegen der Richtung der Sensorelemente. Insbesondere in Abhängigkeit von einer Befestigung der Sensorelemente am Bedienkörper, können bspw. unterschiedliche Betätigungswünsche je nach Druckposition durch das erste und zweite Sensorsignal detektiert werden und/oder von Fehlbetätigungen unterschieden werden.

Vorzugsweise kann bei einem erfindungsgemäßen Verfahren vorgesehen sein, dass zusätzlich zu den Abweichungsrichtungen jeweils zumindest eine Signalamplitude des ersten und zweiten Sensorsignals beim Erkennen der Betätigung berücksichtigt wird. Somit kann nicht nur die Richtung zum Lokalisieren der Deformation herangezogen werden, sondern zusätzlich die jeweilige Signalamplitude selbst. Bei der Signalamplitude kann es sich insbesondere um eine Abweichungsgröße von der Referenz handeln. Durch die Berücksichtigung der Signalamplitude kann somit auch eine Stärke der Auslenkung identifiziert werden und somit einer beabsichtigten oder unbeabsichtigten Betätigungshandlung zugeordnet werden. Dadurch, dass dies für das erste und zweite Sensorsignal berücksichtigt wird, kann ferner die Genauigkeit der Lokalisation der Deformation verbessert sein. Insbesondere kann ein vollständiges Signalbild der Sensorsignale vorgegeben sein, das ein Charakteristikum einer beabsichtigten Betätigungshandlung darstellt. Es kann vorgesehen sein, dass die Deformation erst als beabsichtigte Betätigungshandlung erkannt wird, wenn die Sensorsignale das vorgegebene Signalbild wiederspiegeln.

Ferner kann bei einem erfindungsgemäßen Verfahren vorgesehen sein, dass das Verfahren folgenden Schritt umfasst:
- Erzeugen eines dritten Sensorsignals, insbesondere durch ein drittes Sensorelement, infolge der Deformation des Bedienkörpers,
wobei eine spezifische Abweichungsrichtung des dritten Sensorsignals beim Erkennen der Betätigung berücksichtigt wird. Vorzugsweise kann das erste Sensorsignal einem Sensorelement zugeordnet sein, das zwischen dem zweiten und dem dritten Sensorelement angeordnet ist. Dadurch kann z.B. eine Fehlbedienung ausgeschlossen werden, bei welcher eine zu den Sensorelementen symmetrische Deformation an zwei Druckpunkten erfolgt. So ist es denkbar, dass durch eine derartige Deformation an zwei symmetrischen Druckpunkten die Abweichungsrichtung des zweiten und dritten Sensorsignals übereinstimmt, jedoch die Abweichungsrichtung des ersten Sensorsignals abweicht. In diesem Fall kann eine Deformation am ersten Sensorelement ausgeschlossen werden. Somit kann durch das dritte Sensorsignal eine genauere Lokalisation der Deformation (Bestimmung des Druckpunktes der Betätigung) erfolgen und/oder eine Bewertung, ob die Deformation gewollt (beabsichtigt) ist oder ungewollt (unbeabsichtigt) ist, verbessert sein.

Im Rahmen der Erfindung ist es ferner denkbar, dass das Verfahren folgenden Schritt umfasst:
- Entfernen unerwünschter Signalstörungen, insbesondere in Form von Signalspitzen des ersten und/oder zweiten Sensorsignals.

Dabei kann ein Filtern der Sensorsignale erfolgen, um Betätigungshandlungen von ungewollten (zufälligen) Umwelteinflüssen und/oder Messfehlern unterscheiden zu können. Insbesondere kann das Entfernen der unerwünschten Signalstörungen ein Entprellen des jeweiligen Sensorsignals umfassen. Dadurch kann Genauigkeit beim Erkennen der Betätigung und/oder Deformation kann weiter verbessert sein.

Vorzugsweise wird bei einem erfindungsgemäßen Verfahren beim Erzeugen des ersten und/oder zweiten Sensorsignals jeweils ein Mittelwert eines Messsignals gebildet. Die Sensorsignale können somit aufbereitete Messignale umfassen. Durch die Mittelwertbildung können weitere Störgrößen in den Sensorsignalen reduziert werden und damit die Erkennung der Deformation verbessert sein. Der Mittelwert kann ein Arithmetisches Mittel und/oder einen Median umfassen. Zur Bildung des Mittelwertes können eine Signalstärke, eine Signalfrequenz und/oder dergleichen herangezogen werden. Insbesondere können somit weitere Signalschwankungen eines Messsignals ausgeglichen werden und zu einem Sensorsignal verarbeitet werden, welches in Bezug auf die Deformation einfacher auszuwerten ist.

Ferner kann ein erfindungsgemäßes Verfahren folgenden Schritt umfassen:
- Anpassen der Referenz an einen (ungewollten oder gewollten) Deformationszustand des Bedienkörpers, insbesondere während des Erzeugens des ersten und/oder zweiten Sensorsignals.

Vorzugsweise kann eine Referenzwertnachführung durch das Anpassen der Referenz realisiert sein. Dadurch können z.B. von außen induzierten Spannungs- und/oder Deformationszuständen im Bedienkörper von der Auswertung ausgeschlossen werden. Somit kann der Einfluss von Störgrößen weiter reduziert werden.

Weiterhin kann bei einem erfindungsgemäßen Verfahren vorgesehen sein, dass zumindest ein Referenzgrenzwert vorgegeben wird, ab welchem das Anpassen der Referenz unterbrochen wird, insbesondere sodass eine Signalamplitude ausgehend vom Referenzgrenzwert erfasst wird. So kann vorgesehen sein, dass das Anpassen der Referenz bis zu einem vorbestimmten Wert, d.h. dem Referenzgrenzwert, durchgeführt wird. Der Referenzgrenzwert kann z.B. anhand von üblichen Temperaturschwankungen und der daraus folgenden Deformation des Bedienkörpers vorbestimmt sein. Durch den Referenzgrenzwert kann eine einfache Möglichkeit geschaffen sein eine Referenzwertnachführung zu realisieren und eine Betätigung erkennen zu können. Weiterhin kann vorgesehen sein, dass der Referenzgrenzwert zeitabhängig ist. Dadurch können z.B. sich langsam verändernde Deformationen von schnellen Deformationen unterschieden werden.

Grundsätzlich kann bei der Anpassen der Referenz an den (ungewollten / gewollten) Deformationszustand (im Rahmen der Erfindung) zwischen der
a) ungewollten Änderung des Deformationszustandes des Bedienkörpers (ungewollte Deformation) durch äußere unvermeidbare Einflüsse, wie z.B. Umwelteinflüsse (Temperatur-, Druck-, Schallveränderungen) etc., und
b) der gewollten Änderung des Deformationszustandes des Bedienkörpers (gewollte Deformation) durch gewollte Einflüsse durch einen Bediener bei einer Betätigung des Bedienkörpers
unterschieden werden.

In den beiden Fällen a) und b) kann ein Anpassen der Referenz an einen Deformationszustand des Bedienkörpers in Abhängigkeit von der Abweichung des Sensorsignals (wie zuvor im Text aufgeführt) erfolgen. Auch ist es denkbar, dass nur bei der ungewollten Änderung des Deformationszustandes des Bedienkörpers (Fall a)) die Anpassen der Referenz an einen Deformationszustand des Bedienkörpers in Abhängigkeit von der Abweichung des Sensorsignals erfolgt. Die ungewollte Änderung des Deformationszustandes ist messtechnisch bspw. durch die Geschwindigkeit der Änderung des Deformationszustandes und/oder durch die maximale Änderung des Deformationszustandes innerhalb einer Zeitspanne ΔT von der gewollten Änderung des Deformationszustandes deutlich zu unterscheiden.

Weiterhin kann bei einem erfindungsgemäßen Verfahren vorgesehen sein, dass das Verfahren folgenden Schritt umfasst:
- Ausgeben eines Betätigungssignals zum Ansteuern einer elektrischen Funktion, insbesondere wobei das Betätigungssignal eine Betätigungsamplitude aufweist, deren Richtung unabhängig von der Referenz ist.

Somit kann die Betätigung durch das Verfahren erkannt und verarbeitet werden. Anhand des Betätigungssignals kann die elektrische Funktion ausgelöst werden. Die elektrische Funktion kann eine Funktion eines Kraftfahrzeuges betreffen, wie z.B. das Öffnen eines beweglichen Teils, insbesondere in Form eines Kofferraums oder einer Kraftfahrzeugtür, das Aktivieren eines Schlosses oder dergleichen. Die Betätigungsamplitude kann dabei unabhängig von der Referenz und insbesondere auch unabhängig von den Sensorsignalen sein. So können die Sensorsignale dazu herangezogen werden die Deformation an sich zu erkennen, wobei entsprechend eine Auswertung der Sensorsignale bei einem positiven Erkennen der Deformation zum Ausgeben des Betätigungssignals führt. Durch die Unabhängigkeit von der Referenz kann das Betätigungssignal ferner der elektrischen Funktion eine eindeutige Information übermitteln, die unabhängig von der Deformation bzw. einem Zug- oder Druckspannungszustand des Bedienkörpers ist. Dadurch können die Anforderungen an eine Elektronik zur Interpretation des Betätigungssignals gesenkt und die Kompatibilität der Sensorvorrichtung verbessert sein.

Vorzugsweise kann einem erfindungsgemäßen Verfahren ein Auslöseparameter vorgegeben werden und das Ausgeben des Betätigungssignals erfolgen, wenn der Auslöseparameter durch zumindest eines der Sensorsignale oder alle Sensorsignale, insbesondere zumindest eine der Signalamplituden der Sensorsignale, erreicht wird. Durch den Auslöseparameter kann ein Auslösekriterium gegeben sein, welches sich auf die Signalamplitude des ersten und/oder zweiten Sensorsignals bezieht. Somit kann bis zum Ausgeben des Betätigungssignals nicht nur gefordert sein, dass die Deformation eine spezifische Abweichungsrichtung aufweist, d.h. insbesondere an einer bestimmten Position erfolgt, sondern ferner auch über eine bestimmte Zeit aufrecht erhalten wird. Ferner kann der Deformationszustand eine bestimmte Deformationsstärke aufweisen, die sich in der Signalamplitude wiederspiegeln kann.

Ferner kann bei einem erfindungsgemäßen Verfahren ein Deaktivierungsparameter vorgegeben werden und das Ausgeben des Betätigungssignals angehalten werden, wenn der Deaktivierungsparameter während des Ausgebens des Betätigungssignals durch zumindest eines der Sensorsignale, insbesondere zumindest eine der Signalamplituden der Sensorsignale, erreicht wird. Unter dem Anhalten des Betätigungssignals kann verstanden werden, dass das Betätigungssignal vollständig ausgesetzt wird oder einen Signalverlauf aufweist, welcher eine Nichtbetätigung signalisiert. Der Deaktivierungsparameter kann vorzugsweise mit der Referenz angepasst werden. Insbesondere kann der Deaktivierungsparameter einen Schwellwert entgegengesetzt zur Abweichungsrichtung der Sensorsignale bilden, ab welchem ein Stopp der Betätigungshandlung erkannt wird. Somit kann z.B. durch den Auslöseparameter ein oberer Schwellwert gegeben sein, ab welchen die Betätigungshandlung ausgelöst wird und wenn das Sensorsignal unter den Deaktivierungsparameter fällt kann ein Stopp der Betätigung erkannt werden.

Vorzugsweise kann bei einem erfindungsgemäßen Verfahren vorgesehen sein, dass der Auslöseparameter und/oder der Deaktivierungsparameter in Abhängigkeit von der Referenz angepasst werden. Somit kann eine Referenzwertnachführung auch auf den Auslöseparameter und/oder Deaktivierungsparameter übertragen werden, sodass in Abhängigkeit von der Referenzwertnachführung auf einfache Art und Weise die Betätigung erkannt werden kann. Dadurch können äußere Einflüsse auf den Deformationszustand des Bedienkörpers berücksichtigt werden und zu einer verbesserten Genauigkeit bzw. einer Reduktion von Fehlbetätigungen führen. Vorzugsweise kann für jede der Abweichungsrichtungen ein Auslöseparameter und/oder ein Deaktivierungsparameter vorgegeben und/oder angepasst werden.

Gemäß einem weiteren Aspekt der Erfindung ist ein Computerprogrammprodukt beansprucht. Das Computerprogrammprodukt umfasst Befehle, die bei einer Ausführung, insbesondere der Befehle und/oder des Programms, durch eine Kontrolleinheit die Kontrolleinheit veranlassen ein erfindungsgemäßes Verfahren auszuführen.

Somit kann das Verfahren insbesondere durch Ausführung der Befehle bzw. des Programms durch die Kontrolleinheit durchgeführt werden. Das Computerprogrammprodukt kann als Anweisungscode in einer Programmiersprache, wie z.B. Java, C++ oder dergleichen implementiert sein. Bei der Kontrolleinheit kann es sich um eine Rechnereinheit, einen Mikroprozessor und/oder dergleichen handeln. Insbesondere kann der Anweisungscode die Kontrolleinheit derart programmieren, dass die gewünschten Funktionen ausgeführt werden. Das Computerprogrammprodukt kann in einem Netzwerk, z.B. dem Internet oder einem lokalen Netzwerk, bereitgestellt werden und/oder herunterladbar sein. Ferner ist es denkbar, dass das Computerprogrammprodukt durch eine oder mehrere elektronische Schaltungen in Hardware oder in beliebig hybrider Form, d.h. mittels Softwarekomponenten und Hardwarekomponenten realisiert werden bzw. sein kann.

Gemäß einem weiteren Aspekt der Erfindung ist eine Sensorvorrichtung für eine Betätigung durch eine Deformation eines Bedienkörpers beansprucht. Die Sensorvorrichtung weist zumindest ein erstes und ein zweites Sensorelement auf, die zum Erfassen einer Deformation des Bedienkörpers jeweils in einem Abstand zum Bedienkörper anordbar sind. Ferner weist die Sensorvorrichtung eine Kontrolleinheit zum Auswerten eines ersten Sensorsignals des ersten Sensorelementes infolge der Deformation und eines zweiten Sensorsignals des zweiten Sensorelementes infolge der Deformation auf. Weiterhin weist die Kontrolleinheit ein Erkennungsmodul zum Erkennen der Betätigung in Abhängigkeit von jeweils zumindest einer spezifischen Abweichungsrichtung des ersten und zweiten Sensorsignals von einer Referenz auf.

Die Sensorsignale können sich auf einen Mittelwert insbesondere von Signalamplituden, des ersten und/oder zweiten Sensorelementes beziehen. Insbesondere kann ferner die Referenz auf einen Mittelwert bezogen sein. Weiterhin kann das Erkennungsmodul zum Lokalisieren der Deformation in Bezug auf das erste und zweite Sensorelement ausgebildet sein. Die spezifische Abweichungsrichtung kann eine positive und/oder negative Richtung des Sensorsignals, insbesondere einer Signalamplitude des Sensorsignals, umfassen. Vorzugsweise können das erste und zweite Sensorelement den gleichen Abstand zum Bedienkörper aufweisen und/oder gemeinsam am Bedienkörper als Baueinheit anordbar sein. Somit bringt eine erfindungsgemäße Sensorvorrichtung die gleichen Vorteile mit sich, wie sie bereits ausführlich mit Bezug auf ein erfindungsgemäßes Verfahren beschrieben worden sind. Vorzugsweise kann bei einer erfindungsgemäßen Sensorvorrichtung vorgesehen sein, dass die Kontrolleinheit, insbesondere das Erkennungsmodul, zum Ausführen eines erfindungsgemäßen Verfahrens ausgebildet ist.

Vorzugsweise kann bei einer erfindungsgemäßen Sensorvorrichtung das erste und zweite Sensorelement mit einem Befestigungselement verbunden sein, durch welches das erste und zweite Sensorelement am Bedienkörper befestigbar sind. Zusätzlich oder alternativ kann die Sensorvorrichtung zumindest eine Anschlussleitung zum Anschluss des ersten oder zweiten Sensorelementes an eine Elektronik aufweisen. Die Anschlussleitung kann separat zum Befestigungselement am Bedienkörper oder einem weiteren Bauteil befestigbar sein. Durch das Befestigungselement, welches das erste und zweite Sensorelement verbindet, kann somit eine Baueinheit geschaffen sein, durch welche das erste und zweite Sensorelement in einfacher Art und Weise in einem definierten Abstand zueinander und/oder zum Bedienkörper am Bedienkörper anordbar sind. Darüber hinaus kann durch das Befestigungselement sichergestellt sein, dass die Sensorelemente auch im Betrieb aneinandergekoppelt sind, d.h. z.B. bei einer Bewegung des Bedienkörpers dieser Bewegung gleichzeitig folgen können.

Vorzugsweise kann bei einer erfindungsgemäßen Sensorvorrichtung vorgesehen sein, dass das Befestigungselement zumindest zwei Befestigungsabschnitte aufweist, zwischen denen das erste und zweite Sensorelement angeordnet sind. Die Befestigungsabschnitte können insbesondere miteinander verbunden sein. Vorzugsweise können die Befestigungsabschnitte einen ringförmigen Befestigungsbereich bilden. Das erste und zweite Sensorelement können innerhalb des ringförmigen Befestigungsbereiches angeordnet sein. Durch die zumindest zwei Befestigungsabschnitte zwischen denen das erste und zweite Sensorelement angeordnet sind, kann z.B. eine symmetrische Kraft außerhalb der Sensorelemente und insbesondere außerhalb der Befestigungsabschnitte von einer zentralen Betätigungskraft unterscheidbar sein. So ist z.B. bei einer mittigen Befestigung zwischen dem ersten und zweiten Sensorelement eine solche symmetrische Kraft nicht von einer zentrischen Betätigungskraft unterscheidbar, da eine Biegelinie des Bedienkörpers übereinstimmt. Durch die äußere Befestigung führt somit eine symmetrische Kraft außerhalb der Sensorvorrichtung am Bedienkörper zu einem anderen Deformationsverlauf, als eine zentrische Betätigungskraft.

Weiterhin ist es im Rahmen der Erfindung denkbar, dass die Kontrolleinheit eine Sensorplatine aufweist, die mit den Sensorelementen und/oder dem Befestigungselement zu einer am Bedienkörper montierbaren Baugruppe verbunden ist. Somit kann eine Elektronik zum Auswerten mit dem ersten und zweiten Sensorelement physisch verbunden sein und die Baugruppe bilden. Damit ist die Montage der Sensorvorrichtung am Bedienkörper vereinfacht und die Handhabung bei der Produktion der Sensorvorrichtung vereinfacht.

Ferner kann bei einer erfindungsgemäßen Sensorvorrichtung ein drittes Sensorelement vorgesehen sein, das zum Erfassen der Deformation des Bedienkörpers in einem Abstand zum Bedienkörper anordbar ist, wobei eine spezifische Abweichungsrichtung eines dritten Sensorsignals, das dem dritten Sensorsignal zuordbar ist, infolge der Deformation durch das Erkennungsmodul beim Erkennen der Betätigung berücksichtigbar ist. Weiterhin kann vorgesehen sein, dass die Sensorvorrichtung lediglich drei Sensorelemente aufweist. Durch das dritte Sensorelement kann eine Erkennung, insbesondere Lokalisation der Deformation verbessert sein. Vorzugsweise können die drei Sensorelemente aneinandergereiht nebeneinander angeordnet sein. Dadurch ist insbesondere eine mittlere Betätigung der Sensorvorrichtung besonders genau erkennbar. Darüber hinaus kann dadurch realisiert sein, dass mehrere Betätigungspositionen erkannt werden können.

Die erfindungsgemäße Sensorvorrichtung kann mit ihren vorhandenen Sensorelementen eine Tastatur, insbesondere (10er) Zahlentastatur oder Buchstaben-Tastatur bilden, wobei vorzugsweise die Anzahl der vorhandenen Sensorelemente geringer (und zwar deutlich geringer) ist als die Anzahl der vorhandenen Tasten. So können z.B. mit drei oder vier Sensorelementen der Sensorvorrichtung eine 10er-Tastatur mit 10 Tasten ausgebildet werden, da eine genaue Lokalisation der Deformation / Bestimmung des Druckpunktes der Betätigung durch die Auswertung der Sensorsignale der vorhandenen Sensorelemente erfolgt.

Weiterhin kann bei einer erfindungsgemäßen Sensorvorrichtung vorgesehen sein, dass das erste Sensorelement zentral zwischen den Befestigungsabschnitten und/oder zwischen dem zweiten und dritten Sensorelement angeordnet ist. Damit kann insbesondere eine Betätigung im Bereich des ersten Sensorelementes mit hoher Genauigkeit erkannt werden. Insbesondere können drei Sensorelemente reihenartig zueinander angeordnet sein.

Im Rahmen der Erfindung kann ferner vorgesehen sein, dass es sich bei den Sensorelementen um induktive Sensorelemente, insbesondere in Form von LDC-Sensorelementen, handelt. Vorzugsweise können die Sensorelemente LDC-Spulen umfassen, durch welche eine induktive Erfassung der Deformation ermöglicht ist. Dazu können die Sensorelemente mit einem metallischen Körper wirken, der magnetisierbar und/oder elektrisch leitfähig ist. Dies kann durch den Bedienkörper selbst realisiert sein oder einen Hilfskörper, der am Bedienkörper angeordnet ist. Der Hilfskörper kann z.B. eine metallische Platte umfassen.

Vorzugsweise ist bei einer erfindungsgemäßen Sensorvorrichtung vorgesehen, dass die Kontrolleinheit ein Filtermodul zum Entfernen unerwünschter Signalstörungen, insbesondere in Form von Signalspitzen, des ersten und/oder zweiten und/oder dritten Sensorsignals aufweist. Somit kann die Kontrolleinheit bzw. das Filtermodul zum Entprellen der Sensorsignale ausgebildet sein, sodass Signalspitzen von tatsächlichen Betätigungshandlungen unterschieden werden können. Damit kann die Genauigkeit beim Erkennen der Betätigung verbessert sein.

Im Rahmen der Erfindung kann ferner vorgesehen sein, dass die Kontrolleinheit ein Kompensationsmodul zum Anpassen der Referenz an einen Deformationszustand des Bedienkörpers, insbesondere während des Betriebs der Sensorvorrichtung, aufweist. Somit kann in Abhängigkeit von einer Temperaturänderung und/oder von statischen Spannungszuständen des Bedienkörpers die Referenz angepasst werden, sodass diese Einflüsse aus der Auswertung der Sensorsignale ausgeschlossen werden können. Dadurch ist die Genauigkeit beim Erkennen der Betätigung verbessert, wobei insbesondere zwischen gewollten (bewussten) und ungewollten (zufälligen) Deformationen unterschieden werden kann.

Weiterhin kann bei einer erfindungsgemäßen Sensorvorrichtung vorgesehen sein, dass die Kontrolleinheit ein Ausgabemodul zum Ausgeben eines Betätigungssignals zum Ansteuern einer elektrischen Funktion aufweist, insbesondere wobei das Betätigungssignal eine Betätigungsamplitude aufweist, deren Richtung unabhängig von der Referenz und/oder den Abweichungsrichtungen der Sensorsignale ist. Somit kann durch die Sensorvorrichtung in Abhängigkeit vom Erkennen der Betätigung die elektrische Funktion ausgelöst werden. Insbesondere kann die Auslösung dabei direkt durch die Kontrolleinheit der Sensorvorrichtung erfolgen. Durch die Unabhängigkeit des Betätigungssignals von der Referenz kann somit die Auswertung der Sensorsignale in die Sensorvorrichtung verlagert und nicht etwa einem weiteren Steuergerät überlassen sein.

Vorzugsweise kann bei einer erfindungsgemäßen Sensorvorrichtung vorgesehen sein, dass die Kontrolleinheit ein Speichermodul zum Vorgeben eines Auslöseparameters aufweist, wobei das Ausgeben des Betätigungssignals durchführbar ist, wenn der Auslöseparameter durch zumindest eines der Sensorsignale oder alle Sensorsignale, insbesondere eine Sensorsignalamplitude der Sensorsignale, erreicht wird. Ferner kann bei einer erfindungsgemäßen Sensorvorrichtung vorgesehen sein, dass die Kontrolleinheit ein Speichermodul zum Vorgeben eines Deaktivierungsparameters aufweist, wobei das Ausgeben des Betätigungssignals durch das Ausgabemodul unterbrechbar ist, wenn der Deaktivierungsparameter während des Ausgebens des Betätigungssignals durch zumindest eines der Sensorsignale oder alle Sensorsignale, insbesondere eine Sensorsignalamplitude der Sensorsignale, erreicht wird. Durch das Speichermodul kann in einfacher Art und Weise die Vorgabe des Deaktivierungsparameters erfolgen. Dabei kann der Deaktivierungsparameter werkseitig vorgegeben sein oder anlernbar sein, sodass im Speichermodul der Deaktivierungsparameter veränderbar ist. Der Deaktivierungsparameter kann somit eine Halteschwelle für die Betätigung darstellen.

Vorzugsweise ist bei einer erfindungsgemäßen Sensorvorrichtung das Kompensationsmodul dazu ausgebildet den Auslöseparameter und/oder den Deaktivierungsparameter in Abhängigkeit von der Referenz anzupassen. Somit kann die Referenzwertnachführung auch auf den Auslöseparameter und den Deaktivierungsparameter übertragen werden, sodass auch diese Schwellwerte nachgeführt werden. Dadurch ergibt sich eine vorteilhafte Auswertung der Sensorsignale ergibt, die eine genaue Erkennung der Deformation bzw. des Betätigungswunsches ermöglicht.

Gemäß einem weiteren Aspekt der Erfindung ist ein Fahrzeug aufweisend einen deformierbaren Bedienkörper und eine erfindungsgemäße Sensorvorrichtung beansprucht. Somit bringt ein erfindungsgemäßes Fahrzeug die gleichen Vorteile mit sich, wie sie bereits ausführlich mit Bezug auf ein erfindungsgemäßes Verfahren und/oder eine erfindungsgemäße Sensorvorrichtung beschrieben worden sind. Insbesondere handelt es sich bei dem Fahrzeug um ein Kraftfahrzeug. Bei dem deformierbaren Bedienkörper kann es sich vorzugsweise um ein bewegliches Teil, z.B. in Form von einer Tür und/oder Heckklappe, des Fahrzeugs handeln.

Weitere, die erfindungsverbessernde Maßnahme ergeben sich aus der nachfolgenden Beschreibung zu einigen Ausführungsbeispielen der Erfindung, die in den Figuren schematisch dargestellt sind. Dabei ist zu beachten, dass die Figuren nur beschreibenden Charakter haben und nicht dazu gedacht sind, die Erfindung in irgendeiner Form einzuschränken. Es zeigen schematisch:
- Fig. 1: eine erfindungsgemäße Sensorvorrichtung in einem ersten Ausführungsbeispiel in geschnittener Seitenansicht,
- Fig. 2: die erfindungsgemäße Sensorvorrichtung in schematischer Draufsicht,
- Fig. 3: ein erfindungsgemäßes Kraftfahrzeug mit der erfindungsgemäßen Sensorvorrichtung,
- Fig. 4a+4b: Deformationen bei einem Bedienkörper für die erfindungsgemäße Sensorvorrichtung,
- Fig. 5: ein Bedienkörper für die erfindungsgemäße Sensorvorrichtung,
- Fig. 6: Sensorsignale bei der erfindungsgemäßen Sensorvorrichtung,
- Fig. 7: das Erkennen einer Betätigung bei der erfindungsgemäßen Sensorvorrichtung,
- Fig. 8: ein erfindungsgemäßes Computerprogrammprodukt und ein erfindungsgemäßes Verfahren in schematischer Darstellung.

In den nachfolgenden Figuren werden für die gleichen technischen Merkmale auch von unterschiedlichen Ausführungsbeispielen identische Bezugszeichen verwendet.

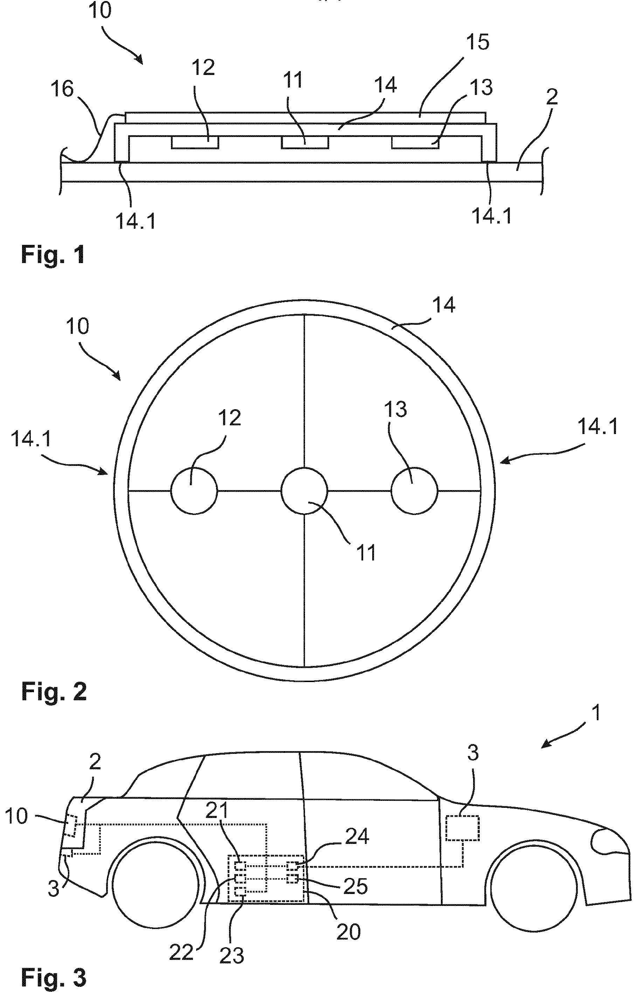

Figur 1 zeigt eine erfindungsgemäße Sensorvorrichtung 10 zum Erkennen 106 einer Betätigung an einem Bedienkörper 2. Vorzugsweise kann es sich bei dem Bedienkörper 2 um ein bewegliches Teil eines Fahrzeuges 1 handeln. So ist in Figur 3 ein erfindungsgemäßes Fahrzeug 1 mit der Sensorvorrichtung 10 dargestellt, wobei der Bedienkörper 2 in Form einer Heckklappe des Fahrzeugs 1 aufgeführt ist. Dabei ist es jedoch ebenfalls denkbar, dass der Bedienkörper 2 als Teil einer Fahrzeugtür, Tankdeckel, Handschuhfach oder dergleichen ausgeführt ist. Durch die Sensorvorrichtung 10 kann eine Deformation am Bedienkörper 2 lokalisiert und damit ein Betätigungswunsch einer Funktionseinheit 3 des Fahrzeugs 1 erkannt werden. Bei der Funktionseinheit 3 kann es sich z.B. um ein Schloss des beweglichen Teils, eine Authentifizierungseinheit zur Authentifizierung des Benutzers oder eine sonstige Fahrzeugfunktion handeln.

Zum Erkennen 106 der Betätigung in Abhängigkeit von der Deformation weist die Sensorvorrichtung 10, wie in den Figuren 1 und 2 dargestellt, ein erstes und ein zweites Sensorelement 11, 12 auf, die zum Erfassen einer Deformation des Bedienkörpers 2 jeweils in einem Abstand zum Bedienkörper 2 angeordnet sind. Vorteilhafterweise weist die Sensorvorrichtung 10 ein drittes Sensorelement 13 auf, das zum Erfassen der Deformation des Bedienkörpers 2 ebenfalls in einem Abstand zum Bedienkörper 2 angeordnet ist. Bei den Sensorelementen 11, 12, 13 handelt es sich vorzugsweise um LDC-Sensorelemente, insbesondere in Form von LDC-Spulen. Die Sensorelemente 11, 12, 13 sind durch ein Befestigungselement 14 verbunden und in einer Reihe zueinander angeordnet. Weiterhin weist das Befestigungselement 14, mit welchem die Sensorelemente 11, 12, 13 am Bedienkörper 2 befestigt sind, zwei Befestigungsabschnitte 14.1 auf, zwischen denen die Sensorelemente 11, 12, 13 angeordnet sind. Insbesondere ist somit eine symmetrische Lagerung in einem Außenbereich der Sensorvorrichtung 10 realisiert. Die zumindest zwei Befestigungsabschnitte 14.1 sind ringförmig miteinander verbunden, sodass sich eine ringförmige Befestigungsfläche zur Befestigung der Sensorvorrichtung 10 am Bedienkörper 2 ergibt.

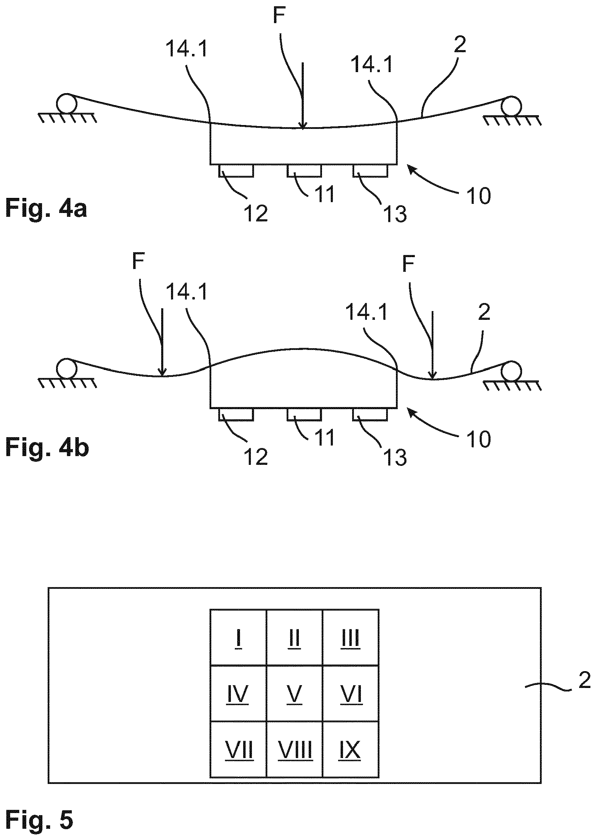

Diese Befestigungsmöglichkeit hat den Vorteil, dass eine Deformation in Folge einer Betätigungskraft F von einer zweiten Deformation in Folge von einer symmetrischen Betätigungskraft F außerhalb des Befestigungselementes 14 unterscheidbar ist. Dies ist bspw. in den Figuren 4a und 4b dargestellt. So zeigt die Figur 4a eine zentrale Betätigungskraft F, die im Bereich des ersten Sensorelementes 11 wirkt und die Figur 4b eine symmetrische Betätigungskraft F, die außerhalb des befestigten Bereiches der Sensorvorrichtung 10 wirkt. Durch die Anordnung der Sensorelemente 11, 12 ,13 zwischen den Befestigungsabschnitten 14.1 ergibt sich somit eine unterscheidbare Deformation des Bedienkörpers 2, die durch die Sensorvorrichtung 10 erfassbar und insbesondere zum Erkennen 106 der Betätigung bewertbar ist.

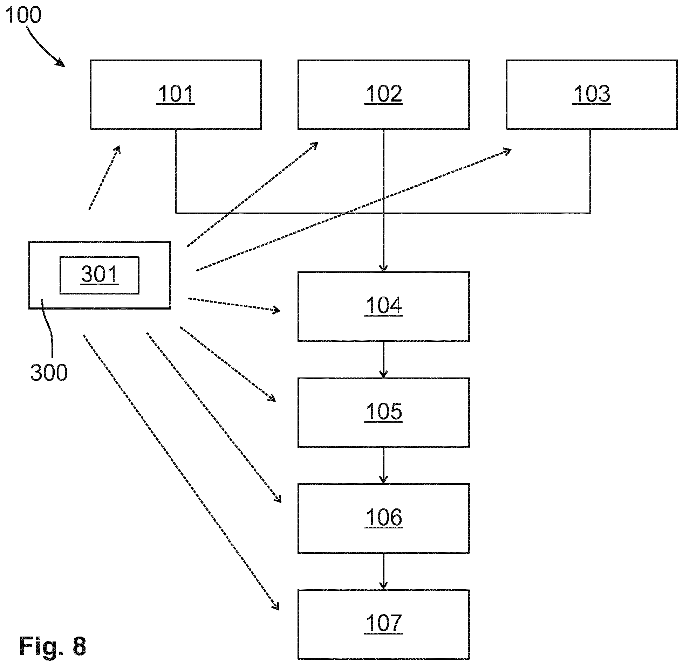

Ferner weist die Sensorvorrichtung 10, wie in Figur 3 dargestellt, eine Kontrolleinheit 20 zum Auswerten von Sensorsignalen 11.1, 12.1, 13.1 der Sensorelemente 11, 12, 13 auf. Die Kontrolleinheit 20 ist vorzugsweise als Sensorsteuereinheit ausgebildet und kann z.B. einen Prozessor und/oder einen Mikrocontroller erfassen. Insbesondere kann die Kontrolleinheit 20 zumindest teilweise auf einer Sensorplatine vorgesehen sein, um eine sensornahe Auswertung der Sensorsignale 11.1, 12.1, 13.1 zu ermöglichen. Es ist jedoch ebenfalls denkbar, dass die Kontrolleinheit 20 in ein zentrales Steuergerät des Fahrzeugs 1 integriert ist. Um eine Verbindung der Kontrolleinheit 20 und/oder der Sensorelemente 11, 12, 13 mit der Funktionseinheit 3 zu ermöglichen, kann die Sensorvorrichtung 10 eine Steuerleitung 16 aufweisen, die vorzugsweise zusätzlich am Bedienkörper 2 befestigbar ist. Die Kontrolleinheit 20 weist ein Erkennungsmodul 21 zum Erkennen 106 der Betätigung anhand der Deformation in Abhängigkeit von spezifischen Abweichungsrichtungen 200.1, 200.2 der Sensorsignale 11.1, 12.1 13.1 von einer Referenz 200 auf. Insbesondere ist durch die Kontrolleinheit 20 ein erfindungsgemäßes Verfahren 100 für eine Betätigung durch die Deformation des Bedienkörpers 2 und/oder ein einfindungsgemäßes Computerprogrammprodukt 300 gemäß Figur 8 ausführbar.

Figur 8 zeigt das erfindungsgemäße Verfahren 100 zum Ausführen der nachfolgend beschriebenen Verfahrensschritte in schematischer Darstellung. Ferner ist das Computerprogramm 300 gezeigt, welches Befehle 301 umfasst, die bei einer Ausführung der Befehle 301 durch die Kontrolleinheit 20 die Kontrolleinheit 20 dazu veranlassen das Verfahren 100 auszuführen.

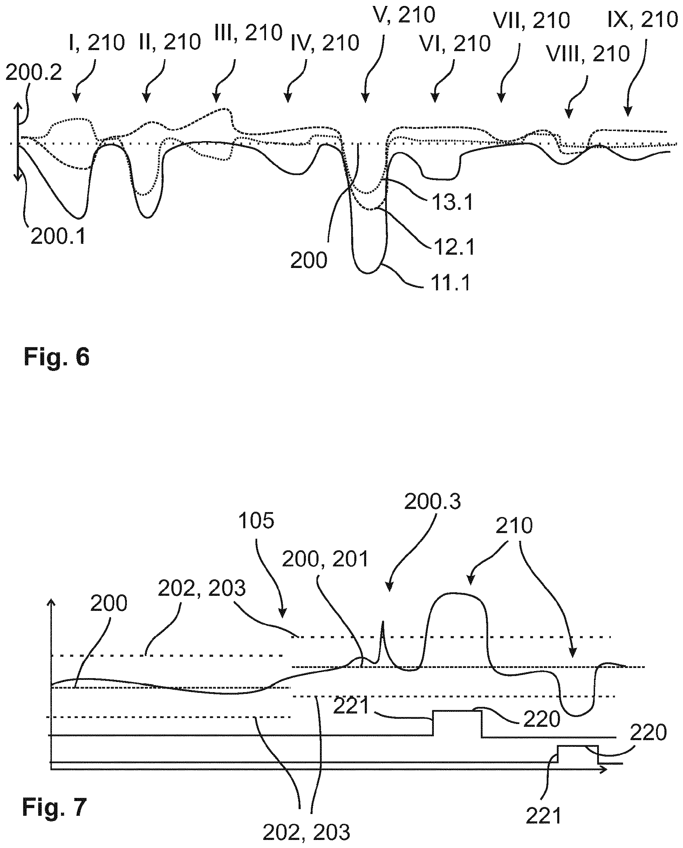

Figur 6 zeigt den Verlauf der Sensorsignale 11.1, 12.1 13.1 und die spezifischen Abweichungsrichtungen 200.1, 200.2. Dabei verlaufen die Sensorsignale 11.1, 12.1, 13.1 in Bezug auf unterschiedliche Positionen I bis IX am Bedienkörper 2 jeweils unterschiedlich. Die Positionen I bis IX am Bedienkörper 2 sind in Figur 5 dargestellt, vorzugsweise wobei die Sensorelemente 11, 12, 13 an den Positionen IV bis VI oder an der Position V hinter dem Bedienkörper 2 angeordnet sind. Ein Druck auf die jeweiligen Positionen I bis IX am Bedienkörper 2 führt zu unterschiedlichen Deformationen des Bedienkörpers 2, welche durch die spezifischen Abweichungsrichtungen 200.1, 200.2 der Sensorsignale 11.1, 12.1, 13.1 abgebildet werden. Der in Figur 6 dargestellte Verlauf ist lediglich schematisch zu verstehen und kann für die Positionen I bis IX abweichen. Insbesondere aufgrund der gezeigten Anordnung der Sensorelemente 11, 12, 13 erzeugt eine Betätigungskraft F auf eine der Positionen I bis IX am Bedienkörper 2 unterschiedliche Signalamplituden 210 der Sensorsignale 11.1, 12.1 13.1 der drei Sensorelemente 11, 12, 13. Die Abweichungsrichtungen 200.1, 200.2 beziehen sich dabei auf eine Referenz 200, von welcher die Signalamplituden 210 ausgehen. So führt bspw. eine Betätigungskraft an der Position I des Bedienkörpers 2 zu einem Druckspannungszustand bzw. zu einer negativen Deformation im Bereich des ersten und zweiten Sensorelementes 11, 12 und damit zu einer negativen Abweichungsrichtung 200.1 der Sensorsignale 11.1, 12.1, aber gleichzeitig zu einem Zugspannungszustand im Bereich des dritten Sensorelementes 13 und damit zu einer positiven Deformation, die wiederrum eine spezifische Abweichungsrichtung 200.2 in positiver Richtung führt. Dadurch kann für jede der Positionen I bis IX ein spezifisches Bild der Sensorsignale 11.1, 12.1, 13.1 vorhanden sein und damit die Deformation lokalisiert und die Betätigung in Abhängigkeit von der Lokalisierung erkannt werden. Insbesondere kann es somit vorgesehen sein, dass das Erkennen 106 der Betätigung der Sensorvorrichtung 10 für den Fall vorgesehen ist, dass die Betätigungskraft F an der mittleren Position V, d.h. mittig der Sensorvorrichtung 10, lokalisiert wird. Dies kann z.B. daran erkannt werden, dass alle spezifischen Abweichungsrichtungen 200.1 negativ sind.

Ein Erzeugen 101, 102, 103 der Sensorsignale 11.1, 12.1, 13.1 erfolgt insbesondere für jedes der Sensorelemente 11, 12, 13 separat und/oder gleichzeitig. Vorzugsweise kann es sich bei den Sensorsignalen 11.1, 12.1, 13.1 um aufbereitete Messsignale handeln, wobei insbesondere jeweils ein Mittelwert gebildet werden kann, um die Sensorsignale 11.1, 12.1, 13.1 zu erzeugen. Figur 7 zeigt ferner exemplarisch anhand eines einzelnen Sensorsignals 11.1, wie dieses vorteilhaft interpretiert werden kann, um Fehlauslösungen zu vermeiden. So ist zum einen ein Entfernen 104 von unerwünschten Signalstörungen 200.3 insbesondere in der Form von Signalspitzen vorgesehen. Für das Entfernen 104 von unerwünschten Signalstörungen 200.3 kann die Kontrolleinheit 20 ein Filtermodul 22 aufweisen. Dadurch können ungewollte (zufällige) Deformationen, z.B. aufgrund von Wind, und/oder Messfehler bereits teilweise aus der Signalauswertung entfernt werden. Weiterhin können am Bedienkörper 2 längerfristige Deformationen auftreten, die z.B. aus Temperaturschwankungen resultieren. Ferner ist ein Anpassen 105 der Referenz 200 an den Deformationszustand des Bedienkörpers 2, insbesondere durch ein Kompensationsmodul 23 der Kontrolleinheit 20, vorgesehen, während das Sensorsignal 11.1 erzeugt wird. Dazu ist ein Referenzgrenzwert 201 vorgegeben, ab welchem das Anpassen 105 der Referenz 200 unterbrochen wird, sodass die Signalamplitude 210 des Sensorsignals 11.1 ausgehend vom Referenzgrenzwert 201 erfasst wird um die Deformation zu erkennen. Bei dem Referenzgrenzwert 201 kann es sich um einen absoluten Wert oder einen zeitabhängigen Parameter handeln. Zusammen mit der Referenz 200 werden ferner ein Deaktivierungsparamater 203 und ein Auslöseparameter 202, insbesondere durch ein Speichermodul 25 der Kontrolleinheit 20, vorgegeben und beim Anpassen 105 der Referenz 200 ebenfalls mitgeführt. Somit ergibt sich eine Nachkalibrierung im Betrieb der Sensorvorrichtung 10, in dem die Kriterien für die Betätigung oder Nichtbetätigung der Sensorvorrichtung 10 verschoben und an den aktuellen Deformationszustand des Bedienkörpers 2 angepasst werden. Der Auslöseparamater 202 ist dabei dazu vorgesehen, dass ein Ausgeben 107 eines Betätigungssignals 220 durch ein Ausgabemodul 24 der Kontrolleinheit 20 gestartet wird. Wie dargestellt, können der Auslöseparameter 202 und der Deaktivierungsparameter 203 identisch sein. Es ist jedoch ebenfalls denkbar, dass sich der Auslöseparameter 202 und der Deaktivierungsparameter 203 unterscheiden und somit z.B. ein Stopp des Erkennens der Betätigung oberhalb oder unterhalb des Auslöseparameters 202 erfolgt. Durch das Betätigungssignals 220 kann ein Ansteuern der elektrischen Funktion der Funktionseinheit 3 des Kraftfahrzeugs 1 erfolgen, wobei das Betätigungssignal 220 eine Betätigungsamplitude 221, deren Richtung unabhängig von der Referenz 200 ist. Dadurch kann unabhängig von der Abweichungsrichtung 200.1, 200.2 der Signalamplitude 210 ein eindeutiges Betätigungssignals 220 ausgegeben werden, das entsprechend von der Funktionseinheit 3 und/oder einer nachfolgenden Steuereinheit in einfacher Art und Weise interpretiert werden kann. Wird nach dem Auslösen der Deaktivierungsparameter 203 durch die jeweilige Signalamplitude 210 erreicht, wird das Ausgeben 107 des Betätigungssignals 220 angehalten. Dabei kann das Betätigungssignal 220 vollständig ausgesetzt werden oder eine Nichtbetätigung signalisieren.

Die voranstehende Erläuterung der Ausführungsform beschreibt die vorliegende Erfindung ausschließlich in Rahmen von Beispielen. Die Erfindung ist durch die nachfolgenden Ansprüche definiert.

### Bezugszeichenliste

- 1: Fahrzeug
- 2: Bedienkörper
- 3: Funktionseinheit
- 4: zentrales Steuergerät

- 10: Sensorvorrichtung
- 11: erstes Sensorelement
- 11.1: erstes Sensorsignal
- 12: zweites Sensorelement
- 12.1: zweites Sensorsignal
- 13: drittes Sensorelement
- 13.1: drittes Sensorsignal
- 14: Befestigungselement
- 14.1: Befestigungsabschnitt
- 15: Sensorplatine
- 16: Steuerleitung

- 20: Kontrolleinheit
- 21: Erkennungsmodul
- 22: Filtermodul
- 23: Kompensationsmodul
- 24: Ausgabemodul
- 25: Speichermodul

- I: erste Position
...
- IX: neunte Position

- F: Betätigungskraft
- 100: Verfahren
- 101: Erzeugen von 11.1
- 102: Erzeugen von 12.1
- 103: Erzeugen von 13.1
- 104: Entfernen von 200.3
- 105: Anpassen von 200
- 106: Erkennen einer Betätigung
- 107: Ausgeben von 220
- 200: Referenz
- 200.1: negative Abweichungsrichtung
- 200.2: positive Abweichungsrichtung
- 200.3: Signalstörung
- 201: Referenzgrenzwert
- 202: Auslöseparameter
- 203: Deaktivierungsparameter
- 210: Signalamplitude
- 220: Betätigungssignal
- 221: Betätigungsamplitude
- 300: Computerprogrammprodukt
- 301: Befehle

## Patentansprüche

1. Verfahren (100) zum Betreiben einer Sensorvorrichtung (10) für eine Betätigung durch eine Deformation eines Bedienkörpers (2) umfassend die folgenden Schritte:
- Erzeugen (101) eines ersten Sensorsignals (11.1) infolge der Deformation des Bedienkörpers (2),
- Erzeugen (102) eines zweiten Sensorsignals (12.1) infolge der Deformation des Bedienkörpers (2),
- Erkennen (106) der Betätigung in Abhängigkeit von jeweils zumindest einer spezifischen Abweichungsrichtung (200.1, 200.2) des ersten und zweiten Sensorsignals (11.1, 12.1) von einer Referenz (200),
wobei über die Abweichungsrichtung (200.1, 200.2) unterscheidbar ist, ob es sich bei der Deformation um eine positive oder eine negative Auslenkung des Bedienkörpers (2) handelt,
wobei das Erkennen (106) der Betätigung in Abhängigkeit der Abweichungsrichtungen (200.1, 200.2) ein Bewerten der Abweichungsrichtungen (200.1, 200.2) umfasst.

2. Verfahren (100) nach Anspruch 1,
**dadurch gekennzeichnet,**
**dass** die Deformation beim Erkennen (106) der Betätigung in Abhängigkeit der spezifischen Abweichungsrichtungen (200.1, 200.2) des ersten und zweiten Sensorsignals (11.1, 12.1) lokalisiert wird,
und/oder dass zusätzlich zu den Abweichungsrichtungen (200.1, 200.2) jeweils zumindest eine Signalamplitude (210) des ersten und zweiten Sensorsignals (11.1, 12.1) beim Erkennen (106) der Betätigung berücksichtigt wird.

3. Verfahren (100) nach einem der vorhergehenden Ansprüche,
**dadurch gekennzeichnet,**
**dass** das Verfahren (100) folgenden Schritt umfasst:
- Erzeugen (103) eines dritten Sensorsignals (13.1) infolge der Deformation des Bedienkörpers (2),
wobei eine spezifische Abweichungsrichtung (200.1, 200.2) des dritten Sensorsignals (13.1) beim Erkennen (106) der Betätigung berücksichtigt wird.

4. Verfahren (100) nach einem der vorhergehenden Ansprüche,
**dadurch gekennzeichnet,**
**dass** das Verfahren (100) folgenden Schritt umfasst:
- Entfernen (104) unerwünschter Signalstörungen (200.3), insbesondere in Form von Signalspitzen, des ersten und/oder zweiten Sensorsignals (11.1, 12.1),
und/oder dass das Verfahren (100) folgenden Schritt umfasst:
- Anpassen (105) der Referenz (200) an einen Deformationszustand des Bedienkörpers (2), insbesondere während des Erzeugens (101, 102) des ersten und/oder zweiten Sensorsignals (11.1, 12.1),
und/oder dass das Verfahren (100) folgenden Schritt umfasst:
- Ausgeben (107) eines Betätigungssignals (220) zum Ansteuern einer elektrischen Funktion, insbesondere wobei das Betätigungssignal (220) eine Betätigungsamplitude (221) aufweist, deren Richtung unabhängig von der Referenz (200) ist.

5. Verfahren (100) nach einem der vorhergehenden Ansprüche,
**dadurch gekennzeichnet,**
**dass** beim Erzeugen (101, 102) der Sensorsignale (11.1, 12.1, 13.1) jeweils ein Mittelwert eines Messsignals gebildet wird,
und/oder dass zumindest ein Referenzgrenzwert (201) vorgegeben wird, ab welchem das Anpassen (105) der Referenz (200) unterbrochen wird, insbesondere so dass die Signalamplitude (210) ausgehend vom Referenzgrenzwert (201) erfasst wird.

6. Verfahren (100) nach einem der vorhergehenden Ansprüche,
**dadurch gekennzeichnet,**
**dass** ein Auslöseparameter (202) vorgegeben wird und das Ausgeben (107) des Betätigungssignals (220) erfolgt, wenn der Auslöseparameter (202) durch zumindest eines der Sensorsignale (11.1, 12.1, 13.1) erreicht wird,
und/oder dass ein Deaktivierungsparameter (203) vorgegeben wird und das Ausgeben (107) des Betätigungssignals (220) angehalten wird, wenn der Deaktivierungsparameter (203) während des Ausgebens (107) des Betätigungssignals (220) durch zumindest eines der Sensorsignale (11.1, 12.1, 13.1) erreicht wird
und/oder dass der Auslöseparameter (202) und/oder der Deaktivierungsparameter (203) in Abhängigkeit von der Referenz (200) angepasst werden.

7. Computerprogrammprodukt (300), umfassend Befehle (301), die bei einer Ausführung durch eine Kontrolleinheit (20) die Kontrolleinheit (20) veranlassen, ein Verfahren (100) nach einem der vorhergehenden Ansprüche auszuführen.

8. Sensorvorrichtung (10) für eine Betätigung durch eine Deformation eines Bedienkörpers (2) aufweisend
ein zumindest erstes und ein zweites Sensorelement (11, 12), die zum Erfassen einer Deformation des Bedienkörpers (2) jeweils in einem Abstand zum Bedienkörper (2) anordbar sind, und
eine Kontrolleinheit (20) zum Auswerten eines ersten Sensorsignals (11.1) des ersten Sensorelementes (11) infolge der Deformation und eines zweiten Sensorsignals (12.1) des zweiten Sensorelementes (12) infolge der Deformation,
**dadurch gekennzeichnet,**
**dass** die Kontrolleinheit (20) ein Erkennungsmodul (21) zum Erkennen der Betätigung in Abhängigkeit von jeweils zumindest einer spezifischen Abweichungsrichtung (200.1, 200.2) des ersten und zweiten Sensorsignals (11.1, 12.1) von einer Referenz (200) aufweist, wobei über die Abweichungsrichtung (200.1, 200.2) unterscheidbar ist, ob es sich bei der Deformation um eine positive oder eine negative Auslenkung des Bedienkörpers (2) handelt, wobei das Erkennen (106) der Betätigung in Abhängigkeit der Abweichungsrichtungen (200.1, 200.2) ein Bewerten der Abweichungsrichtungen (200.1, 200.2) umfasst.

9. Sensorvorrichtung (10) nach Anspruch 8,
**dadurch gekennzeichnet,**
**dass** das erste und zweite Sensorelement (11, 12) mit einem Befestigungselement (14) verbunden sind, durch welches das erste und zweite Sensorelement (11, 12) am Bedienkörper (2) befestigbar sind,
wobei insbesondere dass das Befestigungselement (14) zumindest zwei Befestigungsabschnitte (14.1) aufweist, zwischen denen das erste und zweite Sensorelement (11, 12) angeordnet sind.

10. Sensorvorrichtung (10) nach einem der vorhergehenden Ansprüche,
**dadurch gekennzeichnet,**
**dass** die Kontrolleinheit (20) eine Sensorplatine (15) aufweist, die mit den Sensorelementen (11, 12) und/oder dem Befestigungselement (14) zu einer am Bedienkörper (2) montierbaren Baugruppe verbunden ist.

11. Sensorvorrichtung (10) nach einem der vorhergehenden Ansprüche,
**dadurch gekennzeichnet,**
**dass** ein drittes Sensorelement (13) vorgesehen ist, das zum Erfassen der Deformation des Bedienkörpers (2) in einem Abstand zum Bedienkörper (2) anordbar ist, wobei eine spezifische Abweichungsrichtung (200.1, 200.2) eines dritten Sensorsignals (13.1), welches dem dritten Sensorelement (13) zuordbar ist, infolge der Deformation durch das Erkennungsmodul (21) zum Erkennen der Betätigung berücksichtigbar ist und/oder dass lediglich drei Sensorelemente (11, 12, 13) vorgesehen sind,
und/oder dass das erste Sensorelement (11) zentral zwischen den Befestigungsabschnitten (14.1) und/oder zwischen dem zweiten und dritten Sensorelement (12, 13) angeordnet ist
und/oder dass es sich bei den Sensorelementen (11, 12, 13) um induktive Sensorelemente, insbesondere in Form von um LDC-Sensorelementen, handelt.

12. Sensorvorrichtung (10) nach einem der vorhergehenden Ansprüche,
**dadurch gekennzeichnet,**
**dass** die Kontrolleinheit (20) ein Filtermodul (22) zum Entfernen (104) unerwünschter Signalstörungen (200.3), insbesondere in Form von Signalspitzen, des ersten und/oder zweiten Sensorsignals (11.1, 12.1) aufweist,
und/oder dass die Kontrolleinheit (20) ein Kompensationsmodul (23) zum Anpassen (105) der Referenz (200) an einen Deformationszustand des Bedienkörpers (2), insbesondere während des Betriebs der Sensorvorrichtung (10), aufweist,
und/oder dass die Kontrolleinheit (20) ein Ausgabemodul (24) zum Ausgeben (107) eines Betätigungssignals (220) zum Ansteuern einer elektrischen Funktion aufweist, insbesondere wobei das Betätigungssignal (220) eine Betätigungsamplitude (221) aufweist, deren Richtung unabhängig von der Referenz (200) ist,
und/oder dass die Kontrolleinheit (20) ein Speichermodul (25) zum Vorgeben eines Auslöseparameters (202) aufweist, wobei das Ausgeben (107) des Betätigungssignals (220) durchführbar ist, wenn der Auslöseparameter (202) durch zumindest eine der Signalamplituden (210) erreicht wird,
und/oder dass die Kontrolleinheit (20) ein Speichermodul (25) zum Vorgeben eines Deaktivierungsparameters (203) aufweist, wobei das Ausgeben (107) des Betätigungssignals (210) durch das Ausgabemodul (24) unterbrechbar ist, wenn der Deaktivierungsparameter (203) während des Ausgebens (107) des Betätigungssignals (220) durch zumindest eines der Sensorsignale (11.1, 12.1, 13.1) erreicht wird.

13. Sensorvorrichtung (10) nach einem der vorhergehenden Ansprüche,
**dadurch gekennzeichnet,**
**dass** durch das Kompensationsmodul (23) dazu ausgebildet ist, den Auslöseparameter (202) und/oder den Deaktivierungsparameter (203) in Abhängigkeit von der Referenz (200) anzupassen.

14. Sensorvorrichtung (10) nach einem der vorhergehenden Ansprüche,
**dadurch gekennzeichnet,**
**dass** die Kontrolleinheit (20), insbesondere das Erkennungsmodul (21), zum Ausführen eines Verfahrens (100) nach einem der Ansprüche 1 bis 6 ausgebildet ist.

15. Fahrzeug (1) aufweisend einen deformierbaren Bedienkörper (2) und eine Sensorvorrichtung (10) nach einem der Ansprüche 8 bis 14.

## Claims

1. A method (100) of operating a sensor device (10) for actuation by deformation of an operating element (2) comprising the following steps:
- generation (101) of a first sensor signal (11.1) as a result of the deformation of the operating element (2),
- generation (102) of a second sensor signal (12.1) as a result of the deformation of the operating element (2),
- detection (106) of the actuation as a function of at least one specific direction of deviation (200.1, 200.2) of the first and second sensor signals (11.1, 12.1) from a reference (200),
whereby the direction of deviation (200.1, 200.2) can be used to distinguish whether the deformation is a positive or a negative deflection of the operating element (2),
wherein the detection (106) of the actuation as a function of the deviation directions (200.1, 200.2) comprises an evaluation of the deviation directions (200.1, 200.2).

2. The method (100) according to claim 1,
**characterized in that**
the deformation is localized upon detection (106) of the actuation as a function of the specific deviation directions (200.1, 200.2) of the first and second sensor signals (11.1, 12.1),
and/or **in that**, in addition to the directions of deviation (200.1, 200.2), at least one signal amplitude (210) of the first and second sensor signals (11.1, 12.1) is taken into account when detecting (106) the actuation.

3. The method (100) according to any one of the preceding claims,
**characterized in that**
the method (100) comprises the following step:
- generation (103) of a third sensor signal (13.1) as a result of the deformation of the operating element (2),
wherein a specific deviation direction (200.1, 200.2) of the third sensor signal (13.1) is taken into account when detecting (106) the actuation.

4. The method (100) according to any one of the preceding claims,
**characterized in that**
the method (100) comprises the following step:
- removal (104) of unwanted signal interference (200.3), in particular in the form of signal peaks, of the first and/or second sensor signal (11.1, 12.1),
and/or **in that** the method (100) comprises the following step:
- adaptation (105) of the reference (200) to a deformation state of the operating element (2), in particular during the generation (101, 102) of the first and/or second sensor signal (11.1, 12.1),
and/or **in that** the method (100) comprises the following step:
- output (107) of an actuation signal (220) for actuating an electrical function, in particular wherein the actuation signal (220) has an actuation amplitude (221) whose direction is independent of the reference (200).

5. The method (100) according to any one of the preceding claims,
**characterized in that**
when generating (101, 102) the sensor signals (11.1, 12.1, 13.1), an average value of a measurement signal is formed in each case,
and/or **in that** at least one reference limit value (201) is predetermined, above which the adaptation (105) of the reference (200) is interrupted, in particular so that the signal amplitude (210) is detected starting from the reference limit value (201).

6. The method (100) according to any one of the preceding claims,
**characterized in that**
a triggering parameter (202) is predetermined and the actuation signal (220) is output (107) when the triggering parameter (202) is reached by at least one of the sensor signals (11.1, 12.1, 13.1),
and/or **in that** a deactivation parameter (203) is predetermined and the output (107) of the actuation signal (220) is stopped if the deactivation parameter (203) is reached during the output (107) of the actuation signal (220) by at least one of the sensor signals (11.1, 12.1, 13.1),
and/or that the triggering parameter (202) and/or the deactivation parameter (203) are adapted as a function of the reference (200).

7. A computer program product (300) comprising instructions (301) which, when executed by a control unit (20), cause the control unit (20) to execute a method (100) according to any of the preceding claims.

8. Sensor device (10) for actuation by deformation of an operating element (2), comprising at least a first and a second sensor element (11, 12), which can each be arranged at a distance from the operating element (2) for detecting a deformation of the operating element (2), and
a control unit (20) for evaluating a first sensor signal (11.1) of the first sensor element (11) as a result of the deformation and a second sensor signal (12.1) of the second sensor element (12) as a result of the deformation,
**characterized in that,**
the control unit (20) has a recognition module (21) for recognizing the actuation as a function of in each case at least one specific direction of deviation (200.1, 200.2) of the first and second sensor signals (11.1, 12.1) from a reference (200), it being possible to distinguish via the direction of deviation (200.1, 200.2) whether the deformation is a positive or a negative deflection of the operating element (2), it being the case that the recognition (106) of the actuation as a function of the directions of deviation (200.1, 200.2) comprises an evaluation of the directions of deviation (200.1, 200.2).

9. Sensor device (10) according to claim 8,
**characterized in that**
the first and second sensor elements (11, 12) are connected to a fastening element (14), by means of which the first and second sensor elements (11, 12) can be fastened to the operating element (2),
wherein, in particular, the fastening element (14) has at least two fastening sections (14.1), between which the first and second sensor elements (11, 12) are arranged.

10. Sensor device (10) according to one of the preceding claims,
**characterized in that**
the control unit (20) has a sensor board (15) which is connected to the sensor elements (11, 12) and/or the fastening element (14) to form an assembly which can be mounted on the operating element (2).

11. Sensor device (10) according to one of the preceding claims,
**characterized in that**
a third sensor element (13) is provided, which can be arranged at a distance from the operating element (2) for detecting the deformation of the operating element (2), wherein a specific deviation direction (200.1, 200.2) of a third sensor signal (13.1), which can be assigned to the third sensor element (13), can be taken into account as a result of the deformation by the detection module (21) for detecting the actuation and/or **in that** only three sensor elements (11, 12, 13) are provided,
and/or that the first sensor element (11) is arranged centrally between the fastening sections (14.1) and/or between the second and third sensor elements (12, 13)
and/or that the sensor elements (11, 12, 13) are inductive sensor elements, in particular in the form of LDC sensor elements.

12. Sensor device (10) according to one of the preceding claims,
**characterized in that**
the control unit (20) has a filter module (22) for removing (104) unwanted signal interference (200.3), in particular in the form of signal peaks, from the first and/or second sensor signal (11.1, 12.1),
and/or **in that** the control unit (20) has a compensation module (23) for adapting (105) the reference (200) to a deformation state of the operating element (2), in particular during operation of the sensor device (10),
and/or **in that** the control unit (20) has an output module (24) for outputting (107) an actuation signal (220) for actuating an electrical function, in particular wherein the actuation signal (220) has an actuation amplitude (221) whose direction is independent of the reference (200),
and/or **in that** the control unit (20) has a memory module (25) for specifying a triggering parameter (202), it being possible to output (107) the actuation signal (220) when the triggering parameter (202) is reached by at least one of the signal amplitudes (210),
and/or **in that** the control unit (20) has a memory module (25) for specifying a deactivation parameter (203), it being possible for the output (107) of the actuation signal (210) to be interrupted by the output module (24) if the deactivation parameter (203) is reached by at least one of the sensor signals (11.1, 12.1, 13.1) during the output (107) of the actuation signal (220).

13. Sensor device (10) according to one of the preceding claims,
**characterized in that**
the compensation module (23) is designed to adjust the triggering parameter (202) and/or the deactivation parameter (203) as a function of the reference (200).

14. Sensor device (10) according to one of the preceding claims,
**characterized in that**
the control unit (20), in particular the detection module (21), is designed to carry out a method (100) according to one of claims 1 to 6.

15. A vehicle (1) comprising a deformable operating element (2) and a sensor device (10) according to any one of claims 8 to 14.

## Revendications

1. Procédé (100) pour faire fonctionner un dispositif de capteur (10) pour un actionnement par une déformation d'un corps de commande (2), comprenant les étapes suivantes :
- générer (101) un premier signal de capteur (11.1) suite à la déformation du corps de commande (2),
- générer (102) un deuxième signal de capteur (12.1) suite à la déformation du corps de commande (2),
- détection (106) de l'actionnement en fonction respectivement d'au moins une direction de déviation spécifique (200.1, 200.2) du premier et du deuxième signal de capteur (11.1, 12.1) par rapport à une référence (200),
la direction de déviation (200.1, 200.2) permettant de distinguer si la déformation est une déviation positive ou négative du corps de commande (2),
dans lequel la détection (106) de l'actionnement en fonction des directions de déviation (200.1, 200.2) comprend une évaluation des directions de déviation (200.1, 200.2).

2. Procédé (100) selon la revendication 1,
**caractérisé en ce que**
la déformation est localisée lors de la détection (106) de l'actionnement en fonction des directions de déviation spécifiques (200.1, 200.2) du premier et du deuxième signal de capteur (11.1, 12.1),
et/ou **en ce que**, en plus des directions de déviation (200.1, 200.2), au moins une amplitude de signal (210) du premier et du deuxième signal de capteur (11.1, 12.1) est respectivement prise en compte lors de la détection (106) de l'actionnement.

3. Procédé (100) selon l'une quelconque des revendications précédentes,
**caractérisé en ce que**
le procédé (100) comprend l'étape suivante :
- générer (103) un troisième signal de capteur (13.1) suite à la déformation du corps de commande (2),
une direction de déviation spécifique (200.1, 200.2) du troisième signal de capteur (13.1) étant prise en compte lors de la détection (106) de l'actionnement.

4. Procédé (100) selon l'une quelconque des revendications précédentes,
**caractérisé en ce que**
le procédé (100) comprend l'étape suivante :
- l'élimination (104) de perturbations de signal (200.3) indésirables, en particulier sous la forme de pointes de signal, du premier et/ou du deuxième signal de capteur (11.1, 12.1),
et/ou **en ce que** le procédé (100) comprend l'étape suivante :
- l'adaptation (105) de la référence (200) à un état de déformation du corps de commande (2), en particulier pendant la génération (101, 102) du premier et/ou du deuxième signal de capteur (11.1, 12.1),
et/ou **en ce que** le procédé (100) comprend l'étape suivante :
- émettre (107) un signal d'actionnement (220) pour commander une fonction électrique, en particulier dans lequel le signal d'actionnement (220) présente une amplitude d'actionnement (221) dont la direction est indépendante de la référence (200).

5. Procédé (100) selon l'une quelconque des revendications précédentes,
**caractérisé en ce que**
lors de la génération (101, 102) des signaux de capteur (11.1, 12.1, 13.1), chaque fois une valeur moyenne d'un signal de mesure est formé,
et/ou **en ce qu'**au moins une valeur limite de référence (201) est prédéfinie, à partir de laquelle l'adaptation (105) de la référence (200) est interrompue, en particulier de telle sorte que l'amplitude du signal (210) est saisie à partir de la valeur limite de référence (201).

6. Procédé (100) selon l'une quelconque des revendications précédentes,
**caractérisé en ce qu'**
un paramètre de déclenchement (202) est prédéfini et que l'émission (107) du signal d'actionnement (220) a lieu lorsque le paramètre de déclenchement (202) est atteint par au moins un des signaux de capteur (11.1, 12.1, 13.1),
et/ou **en ce qu'**un paramètre de désactivation (203) est prédéfini et l'émission (107) du signal d'actionnement (220) est arrêtée si le paramètre de désactivation (203) est atteint pendant l'émission (107) du signal d'actionnement (220) par au moins l'un des signaux de capteur (11.1, 12.1, 13.1)
et/ou **en ce que** le paramètre de déclenchement (202) et/ou le paramètre de désactivation (203) sont adaptés en fonction de la référence (200).

7. Produit programme d'ordinateur (300) comprenant des instructions (301) qui, lorsqu'elles sont exécutées par une unité de contrôle (20), amènent l'unité de contrôle (20) à mettre en oeuvre un procédé (100) selon l'une quelconque des revendications précédentes.

8. Dispositif de capteur (10) pour un actionnement par une déformation d'un corps de commande (2), présentant
au moins un premier et un deuxième élément de capteur (11, 12), qui peuvent être disposés respectivement à une distance du corps de commande (2) pour détecter une déformation du corps de commande (2), et
une unité de contrôle (20) pour évaluer un premier signal de capteur (11.1) du premier élément de capteur (11) suite à la déformation et un deuxième signal de capteur (12.1) du deuxième élément de capteur (12) suite à la déformation,
**caractérisé en ce que,**
l'unité de contrôle (20) présente un module de détection (21) pour reconnaître l'actionnement en fonction respectivement d'au moins une direction de déviation spécifique (200.1, 200.2) du premier et du deuxième signal de capteur (11.1, 12.1) par rapport à une référence (200), la direction de déviation (200.1, 200.2) permettant de distinguer s'il s'agit, lors de la déformation, d'une déviation positive ou négative du corps de commande (2), sachant que la détection (106) de l'actionnement en fonction des directions de déviation (200.1, 200.2) comprend une évaluation des directions de déviation (200.1, 200.2).

9. Dispositif de capteur (10) selon la revendication 8,
**caractérisé en ce que**
le premier et le deuxième élément de capteur (11, 12) sont reliés à un élément de fixation (14) par lequel le premier et le deuxième élément de capteur (11, 12) peuvent être fixés sur le corps de commande (2),
dans lequel, en particulier, l'élément de fixation (14) présente au moins deux sections de fixation (14.1) entre lesquelles sont disposés le premier et le deuxième élément de capteur (11, 12).

10. Dispositif de capteur (10) selon l'une des revendications précédentes,
**caractérisé en ce que**
l'unité de contrôle (20) présente une platine de capteur (15) qui est reliée aux éléments de capteur (11, 12) et/ou à l'élément de fixation (14) pour former un sous-ensemble pouvant être monté sur le corps de commande (2).

11. Dispositif de capteur (10) selon l'une des revendications précédentes,
**caractérisé en ce qu'**
il est prévu un troisième élément de capteur (13) qui peut être disposé à une certaine distance du corps de commande (2) pour détecter la déformation du corps de commande (2), une direction de déviation spécifique (200.1, 200.2) d'un troisième signal de capteur (13.1), qui peut être attribué au troisième élément de capteur (13), pouvant être prise en compte par le module de détection (21) suite à la déformation pour détecter l'actionnement et/ou que seuls trois éléments de capteur (11, 12, 13) sont prévus,
et/ou **en ce que** le premier élément de capteur (11) est disposé de manière centrale entre les sections de fixation (14.1) et/ou entre le deuxième et le troisième élément de capteur (12, 13)
et/ou **en ce que** les éléments de capteur (11, 12, 13) sont des éléments de capteur inductifs, notamment sous la forme d'éléments de capteur LDC.

12. Dispositif de capteur (10) selon l'une des revendications précédentes,
**caractérisé en ce que**
l'unité de contrôle (20) présente un module de filtrage (22) pour éliminer (104) des perturbations de signal (200.3) indésirables, en particulier sous forme de pointes de signal, du premier et/ou du deuxième signal de capteur (11.1, 12.1),
et/ou **en ce que** l'unité de contrôle (20) présente un module de compensation (23) pour adapter (105) la référence (200) à un état de déformation du corps de commande (2), en particulier pendant le fonctionnement du dispositif de capteur (10),
et/ou **en ce que** l'unité de contrôle (20) présente un module de sortie (24) pour émettre (107) un signal d'actionnement (220) pour commander une fonction électrique, en particulier le signal d'actionnement (220) présentant une amplitude d'actionnement (221) dont la direction est indépendante de la référence (200),
et/ou **en ce que** l'unité de contrôle (20) présente un module de mémoire (25) pour prédéfinir un paramètre de déclenchement (202), l'émission (107) du signal d'actionnement (220) étant réalisable lorsque le paramètre de déclenchement (202) est atteint par au moins l'une des amplitudes de signal (210),
et/ou **en ce que** l'unité de contrôle (20) présente un module de mémoire (25) pour prédéfinir un paramètre de désactivation (203), l'émission (107) du signal d'actionnement (210) pouvant être interrompue par le module de sortie (24) lorsque le paramètre de désactivation (203) est atteint par au moins l'un des signaux de capteur (11.1, 12.1, 13.1) pendant l'émission (107) du signal d'actionnement (220).

13. Dispositif de capteur (10) selon l'une des revendications précédentes,
**caractérisé en ce que**
le module de compensation (23) est conçu pour adapter le paramètre de déclenchement (202) et/ou le paramètre de désactivation (203) en fonction de la référence (200).

14. Dispositif de capteur (10) selon l'une des revendications précédentes,
**caractérisé en ce que**
l'unité de contrôle (20), en particulier le module de détection (21), est conçue pour mettre en oeuvre un procédé (100) selon l'une des revendications 1 à 6.

15. Véhicule (1) présentant un corps de commande déformable (2) et un dispositif de capteur (10) selon l'une des revendications 8 à 14.
